# EUROPÄISCHE PATENTSCHRIFT

(11) **EP 2 389 727 B1**
(45) Veröffentlichungstag und Bekanntmachung des Hinweises auf die Patenterteilung: **26.02.2020**
(21) Anmeldenummer: 10708891.6
(22) Anmeldetag: 26.01.2010
(51) Int. Cl.: H03K 17/16

(54) **HOCHSPANNUNGSSCHALTER MIT EINSTELLBAREM STROM**
HIGH VOLTAGE SWITCH WITH ADJUSTABLE CURRENT
COMMUTATEUR HAUTE TENSION À COURANT RÉGLABLE

(30) Priorität: 26.01.2009 DE 102009006154
(43) Veröffentlichungstag der Anmeldung: 30.11.2011
(73) Patentinhaber: Bergmann Messgeräte Entwicklung KG, 82418 Murnau (DE)
(72) Erfinder: BERGMANN, Thorald Horst, 82418 Murnau (DE)
(74) Vertreter: Lambsdorff & Lange Patentanwälte Partnerschaft mbB
(86) Internationale Anmeldenummer: PCT/DE2010/075009
(87) Internationale Veröffentlichungsnummer: WO 2010/083827

(56) Entgegenhaltungen:
- EP-A1- 1 580 887
- DE-B3-102007 004 391
- US-A1- 2004 041 201
- US-A1- 2005 224 909

## Beschreibung

Die vorliegende Erfindung betrifft eine Schalteinheit gemäß Patentanspruch 1, sowie eine Push-Pull-Schaltung, eine Brückenschaltung, und ein Lasersystem gemäß der nebengeordneten Patentansprüche.

Für das Schalten von Laserpulsen werden optische Schalter oder Modulatoren verwendet, die entweder innerhalb oder außerhalb des Laser-Resonators im Strahlengang angeordnet werden können. Bei den optischen Modulatoren unterscheidet man prinzipiell zwischen elektrooptischen Modulatoren und akustooptischen Modulatoren. Ein wichtiger Parameter bei dem Einsatz von optischen Modulatoren ist die erreichbare Schaltzeit. Bei akustooptischen Modulatoren wird die erreichbare Schaltzeit durch die Schallgeschwindigkeit und den Laserstrahl-Durchmesser begrenzt, sodass in manchen Fällen die Schaltflanken von akustooptischen Modulatoren zu langsam sind, um beispielsweise Vor- oder Nachpulse in einem kurzen Abstand zum Hauptpuls effektiv zu unterdrücken. Dem gegenüber sind elektrooptische Modulatoren in jüngster Vergangenheit in Richtung auf höhere Taktraten weiterentwickelt worden, sodass sie in der Lage wären, akustooptische Modulatoren bei bestimmten Laser-Anwendungen zu ersetzen, da sie sich durch wesentlich kürzere, elektronisch bedingte Schaltflanken auszeichnen.

Elektrooptische Modulatoren sind im Regelfall so aufgebaut, dass sie eine Pockelszelle als eigentliches optisches Schaltelement mit veränderbaren optischen Eigenschaften und ein polarisations-selektives Element wie beispielsweise einen reflektierenden Analysator mit unveränderbaren optischen Eigenschaften aufweisen. Eine Pockelszelle weist im Allgemeinen einen doppelbrechenden Kristall auf, welcher in geeigneter Weise zu einem einfallenden monochromatischen und polarisierten Lichtstrahl ausgerichtet ist und an den eine elektrische Spannung in der Größenordnung von einigen 100 V bis einigen Kilovolt angelegt wird. In Verbindung mit dem polarisationsabhängigen optischen Element kann die Pockelszelle das Licht in Abhängigkeit von der an sie angelegten elektrischen Spannung
(a) an- oder abschalten oder
(b) auf zwei verschiedenen Pfaden durch ein optisches System lenken.

Die Pockelszelle kann durch eine geeignete schaltbare Hochspannungsversorgung zwischen zwei Zuständen hin und her geschaltet werden, in welchen der aus der Pockelszelle austretende Laserstrahl mit jeweils senkrecht aufeinander stehenden Polarisationsrichtungen linear polarisiert ist. Die Spannung, welche erforderlich ist, um die jeweils zwei genannten Zustände zu erreichen, ist eine Funktion der Kristallparameter und der verwendeten Wellenlänge des zu schaltenden Lichts. Es gibt Anwendungen von Pockelszellen, bei welchen diese schnell an- und abgeschaltet werden müssen, wobei beide Übergangszeiten im Bereich von wenigen Nanosekunden liegen müssen. Bei manchen Anwendungen muss nur eine dieser Übergangszeiten kurz sein, entweder das Anschalten oder das Abschalten, wobei die jeweils andere Übergangszeit durchaus im Bereich von Mikrosekunden liegen kann.

Ein derartiger, aus einer Pockelszelle und einer geeigneten schaltbaren Hochspannungsversorgung aufgebauter elektrooptischer Modulator kann beispielsweise verwendet werden, um kurze Laserpulse mit einer Dauer von wenigen Nanosekunden (ns) oder ultrakurze Laserpulse mit Pikosekunden (ps)- oder Femtosekunden (fs)-Dauer optisch zu schalten, d.h. die Intensität oder die Strahlrichtung der Laserpulse zu ändern. Derartige ultrakurze Laserpulse werden bekanntermaßen durch das Verfahren der Moden-Kopplung erzeugt. Daher haben Laserstrahlquellen für ultrakurze Pulse prinzipbedingt immer sehr hohe Wiederholraten (größer als Megahertz (MHz), typischerweise 40 - 200 MHz für Festkörper-Laser) und niedrige Pulsenergien (im Nanojoule-Bereich, typischerweise 0,1 - 50 nJ). Werden einzelne Pulse oder Pulsgruppen von ps- oder fs-Laserpulsen benötigt, so wird häufig eine Pockelszelle verwendet, um diese Pulse zu selektieren. In diesem Fall muss zunächst zwischen zwei Pulsen, welche die Laserstrahlquelle typischerweise in einem zeitlichen Abstand von 5 - 25 ns aussendet, die Spannung vollständig angeschaltet werden, um nach Durchlassen eines einzigen Laserpulses 5 - 25 ns später vollständig wieder abgeschaltet zu werden.

In vielen Anwendungsfällen wie z.B. im Dokument US 2004/0041201 A1 beschrieben kommt es somit darauf an, möglichst schnelle Schaltzeiten zu erzielen. Es gibt aber auch Situationen, in denen es vorteilhaft ist, wenn zumindest eine der beiden Schaltzeiten langsamer ist als es durch das Schaltelement selbst möglich wäre. Eine Pockelszelle kann beispielsweise innerhalb eines Laserresonators in an sich bekannter Weise als ein Cavity Dumper eingesetzt werden. Hierbei kann es wünschenswert sein, den durch den Cavity Dumper aus dem Resonator ausgekoppelten Puls länger zu machen und seine Spitzenintensität zu verringern. Dies kann durch Verlängern der Schaltzeiten der Ansteuerschaltung der Pockelszelle erreicht werden. Demgemäß werden Hochspannungsschaltungen benötigt, bei welchen wenigstens eine der Schaltflanken langsamer gemacht wird, als es die Schaltelemente normalerweise zulassen würden.

Daher ist es Aufgabe der vorliegenden Erfindung, eine Schalteinheit anzugeben, die es ermöglicht, mindestens eine Schaltflanke zu verzögern.

Diese Aufgabe wird mit den Merkmalen des Patentanspruchs 1 gelöst. Vorteilhafte Weiterbildungen und Ausgestaltungen sind Gegenstand von Unteransprüchen oder nebengeordneten Ansprüchen.

Schalteinheiten oder Hochspannungsschalter der in dieser Anmeldung beschriebenen Art sind als eine Transistorkette aufgebaut, die bezüglich ihrer Laststrecken in Reihe geschaltet sind. Insbesondere sind die Schalteinheiten durch eine Kette aus MOSFET-Transistoren gegeben, die bezüglich ihrer Source-/Drain-Strecken in Reihe geschaltet sind.

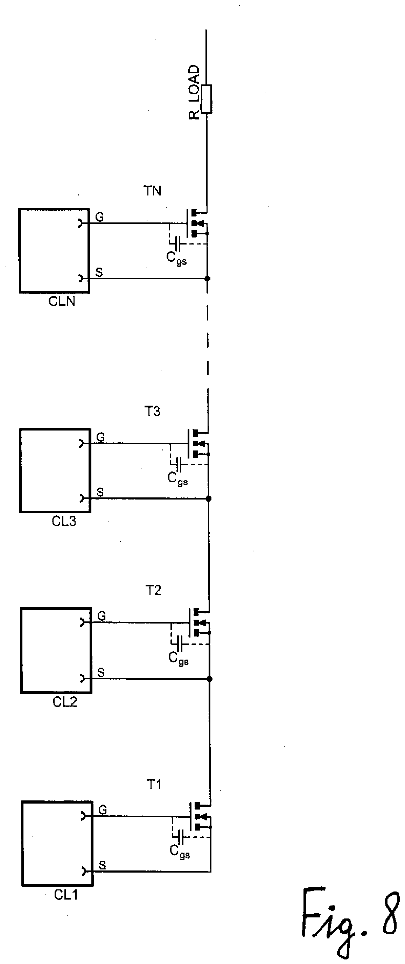

Die Ströme von MOSFET-Schaltern und deren Schaltflanken sind bedingt durch die internen Impedanzen wie Schaltungsinduktivitäten oder Transistor-Impedanzen des Aufbaus der Schaltung. Bei solchen MOSFET-Schaltern kann man im Prinzip die Schaltflanken dadurch verlangsamen, indem man einen oder mehrere Widerstände R_Load in die Strombahn zu der Last wie der Pockelszelle einfügt. Nachteilig bei einer solchen Anordnung, wie in Fig. 8 dargestellt, wäre jedoch die relativ große Leistungserzeugung an diesem Widerstand, der demzufolge womöglich gekühlt werden müsste, und ausserdem relativ viel Platz beanspruchen würde.

Der vorliegenden Erfindung liegt daher eine wesentliche Erkenntnis zugrunde, wonach es besser wäre, den Strom über die Transistoren selbst zu steuern. Dafür muß man in die Laststrecke eine wohlbestimmte Impedanz einfügen, an welcher entsprechend dem Strom, welcher hindurchfließt, eine wohlbestimmte Spannung abfällt. Diese Spannung überträgt man mittels eines Kondensators an die Steuerelektrode Gate des Transistors.

Die Erfindung bezieht sich somit auf eine Schalteinheit, mit einer Mehrzahl von Transistoren, welche bezüglich ihrer Laststrecken in Serie geschaltet sind, wobei mindestens ein Transistor mit seiner Laststrecke mit einer Strom-Messimpedanz verbunden ist, die Strom-Messimpedanz mit einem Kondensator verbunden ist und der Kondensator mit einer Steuerelektrode des Transistors verbunden ist.

Der Transistor ist mit einer Lade-/Entlade-Schaltung verbunden. Der Kondensator kann durch die erfindungsgemäße Anordnung gleichzeitig mit der Gate-Source-Kapazität des MOSFET durch die Lade-/EntladeSchaltung aufgeladen bzw. entladen werden. Auf diese Weise fällt die Leistung direkt an dem Transistor an, wo sie leicht abgeführt werden kann. Außerdem kann man den Strom nicht nur durch die Meß-Impedanz, sondern auch durch die zugeführte Spannung bzw. Ladung von der Lade-/Entlade-Schaltung steuern.

Erfindungsgemäss sind eine Mehrzahl der vorhandenen Transistoren der Schalteinheit, vorzugsweise alle Transistoren jeweils mit ihrer Laststrecke mit einer Strom-Messimpedanz verbunden, welche ihrerseits mit einem Kondensator verbunden ist und der Kondensator mit einer Steuerelektrode des Transistors verbunden ist.

Erfindungsgemäss sind die Transistoren durch Feldeffekt-Transistoren, insbesondere MOS-Transistoren gegeben und die Strom-Messimpedanz ist mit der Source des Transistors verbunden.

In einer Ausführungsform weist die Strom-Messimpedanz einen reellen Widerstand auf.

Erfindungsgemäss ist die Steuerelektrode des Transistors mit einer Lade-/Entlade-Schaltung verbunden.

In einer Ausführungsform ist zu der Strom-Messimpedanz eine Diode parallel geschaltet.

Die erfindungsgemäße Schalteinheit kann auf verschiedene Weise für Spannungsschalter, insbesondere Hochspannungsschalter, eingesetzt werden.

Eine relativ einfache Anordnung besteht in einer sogenannten Push-Pull-Schaltung mit einem Schaltungsknoten, einer ersten erfindungsgemäßen Schalteinheit mit einem ersten Anschluss, welcher mit einem ersten Potential verbunden ist und mit einem zweiten Anschluss, welcher mit dem Schaltungsknoten verbunden ist, und einer zweiten erfindungsgemäßen Schalteinheit, welche mit einem ersten Anschluss mit dem Schaltungsknoten und mit einem zweiten Anschluss mit einem zweiten Potential verbunden ist.

Dabei kann das erste Potential durch einen Pol einer Spannungsquelle und das zweite Potential kann durch Masse gegeben sein. Ebenso kann das erste Potential durch Masse und das zweite Potential kann durch den anderen Pol der Spannungsquelle gegeben sein.

Eine derartige Push-Pull-Schaltung kann als eine Pockelszellen-Ansteuerschaltung ausgestaltet werden, indem ein erster Anschluss einer Pockelszelle mit dem Schaltungsknoten verbunden ist und ein zweiter Anschluss der Pockelszelle mit einem festen Potential verbunden wird.

Eine etwas aufwendigere Anordnung besteht in einer Brückenschaltung mit einem ersten Schaltungsknoten und einem zweiten Schaltungsknoten, wobei der erste Schaltungsknoten durch eine erste Leitung mit einem ersten Potential und durch eine zweite Leitung über eine erste erfindungsgemäße Schalteinheit mit einem zweiten Potential verbunden ist, und der zweite Schaltungsknoten durch eine dritte Leitung mit dem ersten Potential und durch eine vierte Leitung über eine zweite erfindungsgemäße Schalteinheit mit dem zweiten Potential verbunden ist, und mindestens eine weitere erfindungsgemäße Schalteinheit, über die einer der beiden Schaltungsknoten mit dem ersten Potential verbunden ist.

Eine derartige Brückenschaltung kann als eine Pockelszellen-Ansteuerschaltung ausgestaltet werden, indem ein erster Anschluss einer Pockelszelle mit dem ersten Schaltungsknoten und ein zweiter Anschluss der Pockelszelle mit dem zweiten Schaltungsknoten verbunden wird.

Eine wie vorstehend angesteuerte Pockelszelle kann dann als ein Cavity Dumper innerhalb eines Resonators einer Laserstrahlquelle eingesetzt werden. Durch die Verlängerung mindestens einer der Schaltflanken des der Pockelszelle zugeführten elektrischen Schaltpulses kann der von der Pockelszelle ausgekoppelte Laserpuls zeitlich verlängert und seine Spitzenintensität verringert werden.

Im folgenden werden Ausführungsbeispiele der Erfindung anhand der Zeichnungen näher erläutert. Es zeigen:
Fig. 1 eine schematische Darstellung einer erfindungsgemäßen Schalteinheit entsprechend einer Ausführungsform;
Fig. 2 eine schematische Darstellung einer erfindungsgemäßen Schalteinheit entsprechend einer Ausführungsform;
Fig. 3 eine schematische Darstellung einer erfindungsgemäßen Schalteinheit entsprechend einer Ausführungsform;
Fig. 4 eine schematische Darstellung einer Ausführungsform einer Push-Pull-Schaltung mit erfindungsgemäßen Schalteinheiten;
Fig. 5 eine schematische Darstellung einer Ausführungsform einer Brückenschaltung mit einer erfindungsgemäßen Schalteinheit;
Fig. 6 eine schematische Darstellung einer weiteren Ausführungsform einer Brückenschaltung mit einer erfindungsgemäßen Schalteinheit;
Fig. 7 eine schematische Darstellung einer weiteren Ausführungsform einer Brückenschaltung mit einer erfindungsgemäßen Schalteinheit;
Fig. 8 eine schematische Darstellung einer weiteren Schalteinheit;
Fig. 9 eine schematische Darstellung einer Ausführungsform einer Laserstrahlquelle mit einer resonatorinternen Pockelszelle als Cavity Dumper.

Insofern in der folgenden Beschreibung, den Patentansprüchen oder den Zeichnungen zum Ausdruck gebracht wird, dass Schaltungselemente miteinander "verbunden", "elektrisch "verbunden" oder "gekoppelt" sind, so kann dies bedeuten, dass die genannten Elemente direkt, d.h. ohne dazwischen befindliche weitere Elemente, miteinander gekoppelt sind. Es kann jedoch auch bedeuten, dass die genannten Elemente nicht direkt miteinander gekoppelt sind und dass weitere Elemente zwischen die genannten Elemente gekoppelt sind.

Insofern in den Figuren gleiche Bezugszeichen verwendet werden, so beziehen sich diese auf gleiche oder funktionsgleiche Elemente, so dass in diesen Fällen die Beschreibung dieser Elemente nicht wiederholt wird.

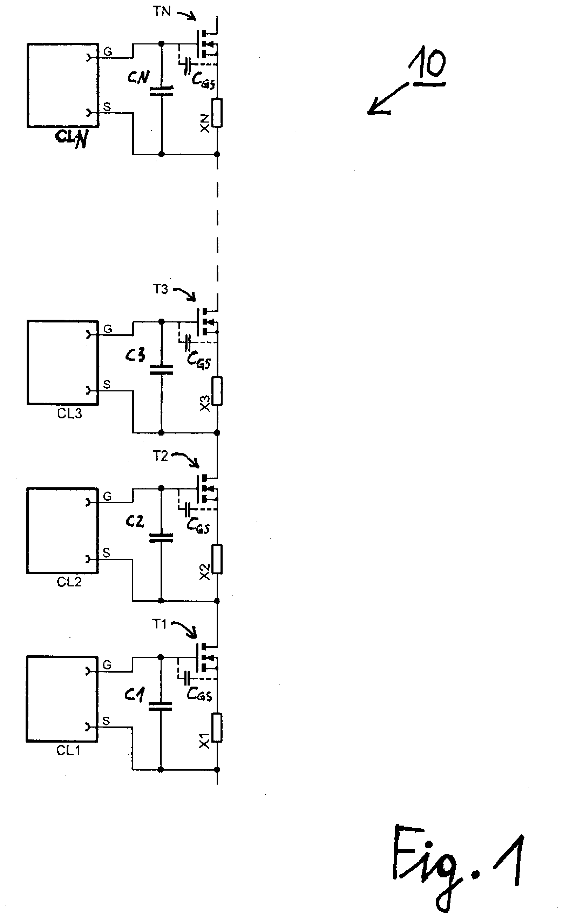

In der Fig. 1 ist eine erfindungsgemäße Schalteinheit entsprechend einer Ausführungsform schematisch dargestellt. Die Schalteinheit 10 besteht im wesentlichen aus einer Transistorkette aus N MOS-Feldeffekttransistoren (MOSFETs) TN, die bezüglich ihrer Source-/Drain-Strecken in Serie geschaltet sind. Die MOSFETs TN werden durch bekannte Lade-/Entlade-Schaltungen CLN an- bzw. abgeschaltet, die jeweils mit dem Gate- und dem Source-Anschluss der MOSFETs TN verbunden sind. Eine solche Anordnung ist als ein Hochspannungsschalter ausgebildet. Hochspannungsschalter können Spannungen bis zu einigen Kilovolt oder einigen 10 Kilovolt schalten. Die Schaltzeiten von derartigen Hochspannungsschaltern liegen im Bereich weniger Nanosekunden und lassen sich beispielsweise durch TTL-Signale mit einem Signalpegel von wenigen Volt ansteuern. Der innere Aufbau dieser Hochspannungsschalter, insbesondere der Lade-/Entlade-Schaltungen CLN, ist beispielsweise in der DE 3630775 C2 beschrieben und braucht somit vorliegend nicht näher erörtert zu werden.

Der Source-Anschluss jedes MOSFETs TN wird erfindungsgemäß mit einer Impedanz XN verbunden. Die Impedanz XN ist über einen Kondensator CN mit dem Gate-Anschluss des MOSFETs TN verbunden. Die Impedanz XN hat die Funktion einer Strom-Messimpedanz. Die an der Impedanz XN abfallende Spannung wird mittels des Kondensators CN an den Gate-Anschluss des MOSFETs TN übertragen. Der Kondensator CN ist schaltungstechnisch real, während jeder MOSFET TN zusätzlich eine lediglich virtuelle oder parasitäre (gestrichelt gezeichnete) Gate-Source-Kapazität C_{GS} aufweist. Der reelle Kondensator CN und der parasitäre Kondensator C_{GS} werden ebenso durch die Lade-/Entlade-Schaltung CLN aufgeladen bzw. entladen.

Die an der Impedanz XN abfallende und den Momentanwert des durch den MOSFET'TN fliessenden Stroms repräsentierende Spannung wird an den Gate-Anschluss des MOSFET übertragen und steuert somit ihrerseits den Strom durch den MOSFET und somit den Gesamtstrom der Transistorkette. Der Strom kann darüberhinaus durch die von der Lade-/Entlade-Schaltung CLN zugeführte Spannung bzw. Ladung gesteuert werden. Eine von der Lade-/Entlade-Schaltung CLN an den MOSFET gelieferte Schaltflanke wird durch die erfindungsgemässe Anordnung verlangsamt. Die Leistung fällt direkt an den MOSFETs TN und den Impedanzen XN an, von wo sie relativ leicht abgeführt werden kann.

Die Impedanz XN kann im einfachsten Fall durch einen einzelnen reellen Widerstand RN gegeben sein. Die Impedanz XN kann jedoch auch durch eine Kombination aus einem Widerstand und einem Kondensator gegeben sein. Des Weiteren ist auch eine Kombination aus einem oder mehreren Widerständen und/oder Kondensatoren und/oder Induktivitäten und/oder nichtlinearen Bauelementen denkbar. Auch kann vorgesehen sein, dass eine wie immer ausgestaltete Kombination dieser Bauelemente einen steuer- oder regelbaren Impedanz- oder Widerstandswert aufweist. Auf diese Weise könnte der Anteil der an das Gate rückgekoppelten Spannung variabel eingestellt werden.

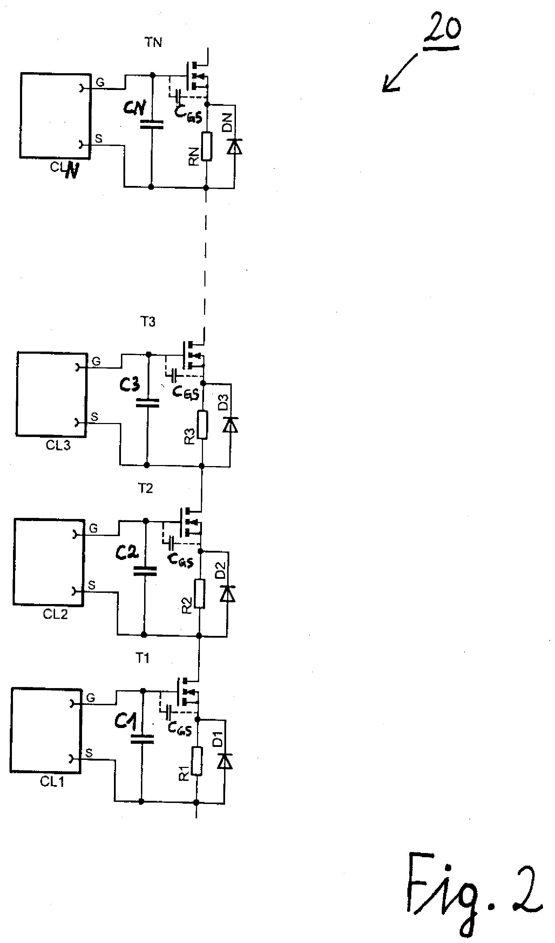

In der Fig. 2 ist eine erfindungsgemäße Schalteinheit entsprechend einer weiteren Ausführungsform schematisch dargestellt, wobei die Strom-Mess-Impedanz nichtlineare Eigenschaften aufweist. Diese Ausführungsform einer Schalteinheit 20 entspricht im Wesentlichen der Ausführungsform der Fig. 1. Die in der Ausführungsform der Fig. 1 gezeigte Impedanz XN ist hier als reeller Widerstand RN dargestellt. Zusätzlich ist bei der Schalteinheit 20 bei jedem MOSFET TN mit einer Diode DN ein nichtlinearer Widerstand vorgesehen, die der Impedanz XN parallelgeschaltet ist. Die Diode DN kann je nach den gewünschten Eigenschaften der Stromsteuerung in Sperrrichtung oder Durchlassrichtung geschaltet sein und wirkt in dem in Fig. 2 dargestellten Beispiel als Strombegrenzer für den in dem parallelen Zweig durch den Widerstand RN fliessenden Strom.

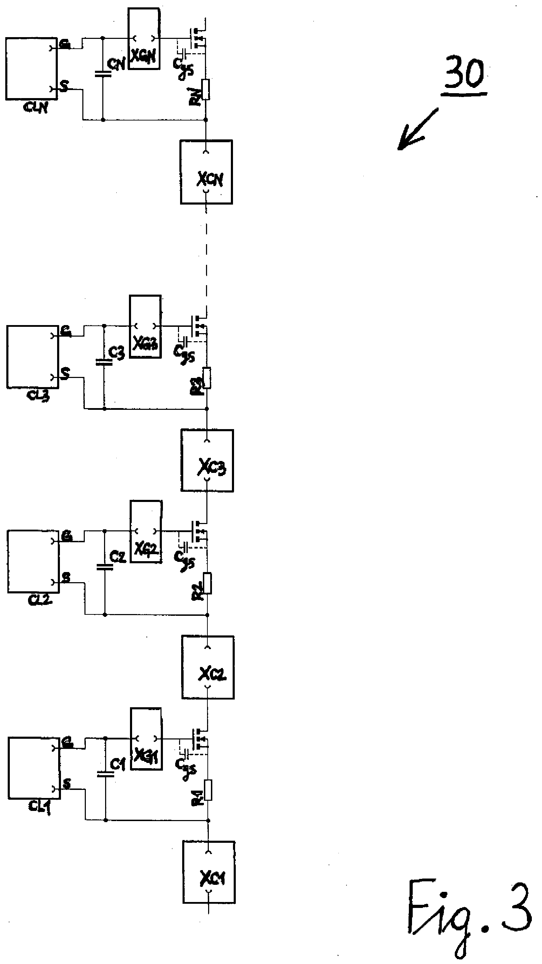

In der Fig. 3 ist eine erfindungsgemäße Schalteinheit entsprechend einer weiteren Ausführungsform schematisch dargestellt. Diese Ausführungsform einer Schalteinheit 30 entspricht im Wesentlichen der Ausführungsform der Fig. 2, wobei die Dioden D1 bis DN weggelassen wurden. Zusätzlich sind bei der Schalteinheit 30 beliebige Schaltungen XCN und/oder XGN vorgesehen, die jeweils zwischen benachbarten MOSFETs TN der Transistorkette zwischengeschaltet sind oder in die Gate-Leitungen der Transistoren eingefügt sind. Zweck dieser Schaltungen kann sein, weitere Änderungen des zeitlichen Verhaltens beim Schalten des Stromes zu bewirken. Die Schaltungen XCN bzw. XGN können im einfachsten Fall ein Widerstand oder ein Widerstand mit einem parallelgeschalteten Kondensator und/oder einer parallelgeschalteten Induktivität sein. Um nichtlineare Eigenschaften zu bewirken, können in diesen Schalteinheiten auch Dioden oder andere nichtlineare Bauteile verwendet werden.

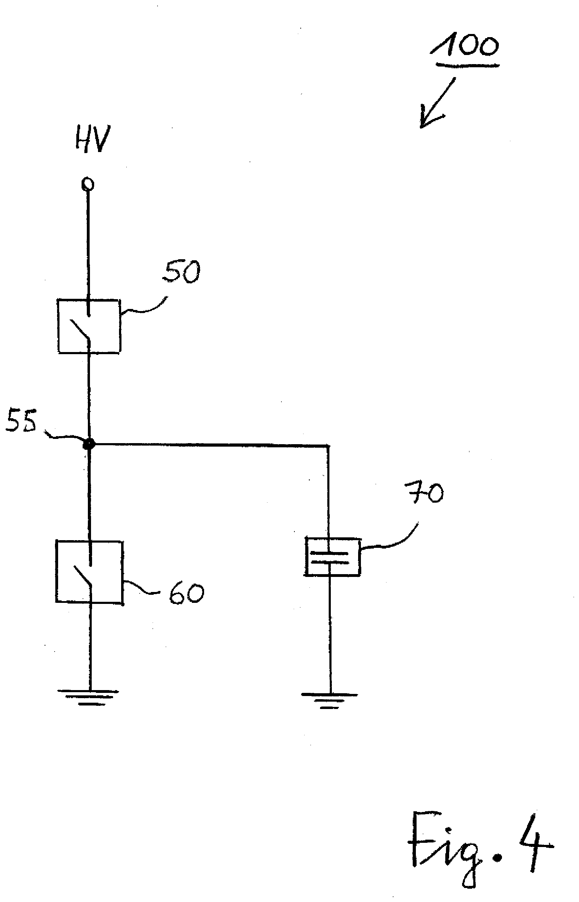

In der Fig. 4 ist eine Ausführungsform einer Push-Pull-Schaltung mit erfindungsgemäßen Schalteinheiten schematisch dargestellt. Die Push-Pull-Schaltung 100 weist eine erste Schalteinheit 50 und eine zweite Schalteinheit 60 auf. Die Schalteinheiten 50 und 60 sind in Reihe zwischen einem ersten Potentialanschluss und einem zweiten Potentialanschluss geschaltet, wobei der erste Potentialanschluss durch einen Hochspannungsanschluss (HV) und der zweite Potentialanschluss durch einen Masseanschluss gegeben sein kann.

Die beiden Schalteinheiten 50 und 60 sind der Übersichtlichkeit halber in Blockform dargestellt und können bezüglich ihres inneren Aufbaus durch erfindungsgemässe Schalteinheiten gegeben, wie sie in einer der Fig. 1-3 dargestellt und oben beschrieben worden sind.

Die erste Schalteinheit 50 ist mit ihrem ersten Anschluss mit dem Hochspannungsanschluss und mit ihrem zweiten Anschluss mit einem Schaltungsknoten 55 verbunden. Die zweite Schalteinheit 60 ist mit ihrem ersten Anschluss mit dem Schaltungsknoten 55 und mit ihrem zweiten Anschluss mit ihrem zweiten Anschluss mit dem Masseanschluss verbunden. Der Schaltungsknoten 55 ist wiederum mit einem ersten Anschluss einer Last 70 wie einer Pockelszelle verbunden. Der zweite Anschluss der Last 70 ist mit dem Masseanschluss verbunden.

Die Push-Pull-Schaltung 100 wird so betrieben, dass stets eine Schalteinheit geschlossen ist, während die jeweils andere Schalteinheit geöffnet ist. Wenn die Schalteinheit 60 geschlossen und die Schalteinheit 50 geöffnet ist, so ist die Last 70 spannungslos. Im umgekehrten Fall liegt die gesamte Hochspannung an der Last 70 an. Es können beide Schalteinheiten 50 und 60 durch erfindungsgemässe Schalteinheiten gegeben sein oder auch nur eine der Schalteinheiten 50 und 60. Das kommt darauf an, ob beide Schaltflanken des an die Last 70 anzulegenden Spannungspulses verzögert werden sollen oder nur eine davon. Wenn beispielsweise nur die ansteigende Flanke des Spannungspulses verzögert werden soll, so ist die Schalteinheit 50 als erfindungsgemässe Schalteinheit auszulegen. Wenn nur die abfallende Flanke des Spannungspulses verzögert werden soll, so ist die Schalteinheit 60 als erfindungsgemässe Schalteinheit auszulegen. Wenn beide Schaltflanken verzögert werden sollen, so sind beide Schalteinheiten 50 und 60 als erfindungsgemässe Schalteinheiten auszulegen. Eine nicht erfindungsgemäss ausgelegte Schalteinheit weist eine Transistorkette auf wie in Fig. 1 gezeigt, wobei die Impedanz XN und der Kondensator CN weggelassen sind.

Es ist auch denkbar, zwar beide Schalteinheiten 50 und 60 als erfindungsgemässe Schalteinheiten auszulegen, jedoch dafür Sorge zu tragen, dass die durch die Schalteinheiten bereitgestellten Verzögerungen veränderbar sind, etwa durch variable Impedanzen XN und/oder variable Kondensatoren CN oder variable Spannungen der Lade-Einheiten CLN.

Eine weitere Ausführungsform einer Ansteuerschaltung ist durch eine Brückenschaltung gegeben, die zwar schaltungstechnisch aufwändiger als die Push-Pull-Schaltung ist, jedoch deren schaltungsdynamische Nachteile bei der Ansteuerung einer Pockelszelle vermeiden kann.

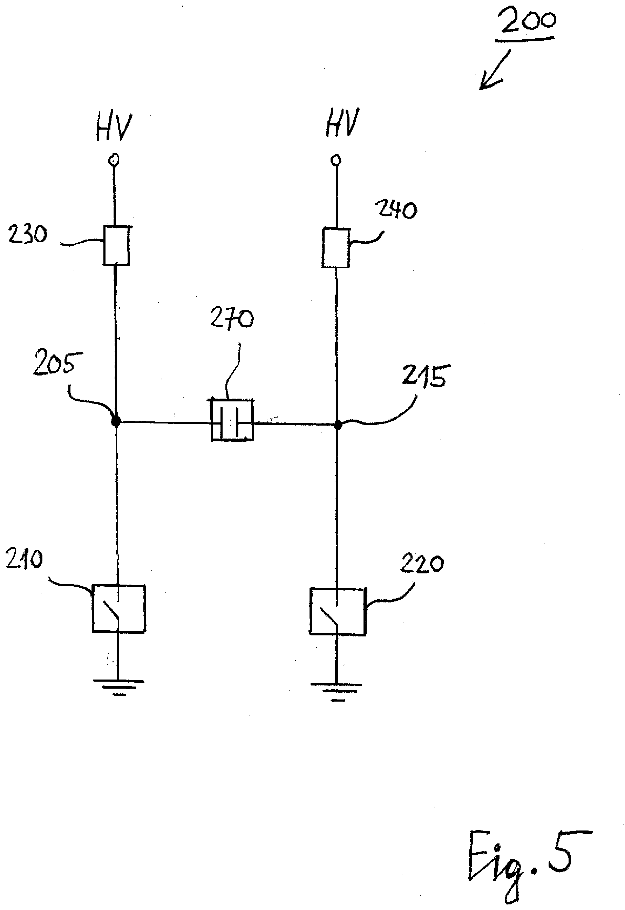

In der Fig. 5 ist eine Ausführungsform einer Brückenschaltung mit erfindungsgemäßen Schalteinheiten schematisch dargestellt. Die Brückenschaltung 200 besteht im wesentlichen aus einer sogenannten H-Konfiguration. Diese an sich bekannte H-Konfiguration weist zwei Schaltungsknoten 205 und 215 auf, die an die elektrischen Anschlüsse einer Last 270 wie einer Pockelszelle anzuschließen sind. Die Schaltungsknoten 205 und 215 sind Ausgangspunkt von vier Leitungen, die den vier Schenkeln des Buchstaben H entsprechen. Der erste Schaltungsknoten 205 ist durch eine erste Leitung über einen ersten Nachladewiderstand 230 mit einem ersten Potentialanschluss wie einem (Hoch-)Spannungsanschluss HV und durch eine zweite Leitung über eine erste Schalteinheit 210 mit einem zweiten Potentialanschluss wie einem Masseanschluss verbunden ist, während der zweite Schaltungsknoten 215 durch eine dritte Leitung über einen zweiten Nachladewiderstand 240 mit dem ersten Potentialanschluss und durch eine vierte Leitung über eine zweite Schalteinheit 220 mit dem Masseanschluss verbunden ist.

Die beiden Schalteinheiten 210 und 220 sind der Übersichtlichkeit halber in Blockform dargestellt und können bezüglich ihres inneren Aufbaus durch erfindungsgemässe Schalteinheiten gegeben sein, wie sie in einer der Fig. 1-3 dargestellt und oben beschrieben worden sind. Es gilt diesbezüglich dasselbe wie bei der zuvor beschriebenen Push-Pull-Schaltung. Die beiden Schalteinheiten 210 und 220 werden angesteuert, um einen Spannungspuls an die Last 270 zu liefern. Wenn nur eine Schaltflanke des Spannungspulses verzögert werden soll, so ist auch nur eine der Schalteinheiten 210 und 220 als erfindungsgemässe Schalteinheit auszulegen. Sollen beide Schaltflanken verzögert werden, so sind beide Schalteinheiten 210 und 220 als erfindungsgemässe Schalteinheiten auszulegen.

Weitere Ausführungsformen von Brückenschaltungen können dadurch gebildet werden, indem mindestens eine weitere erfindungsgemässe Schalteinheit hinzugefügt wird, welche zu einem oder beiden der Nachladewiderstände parallelgeschaltet wird und/oder einen oder beide Nachladewiderstände komplett ersetzt.

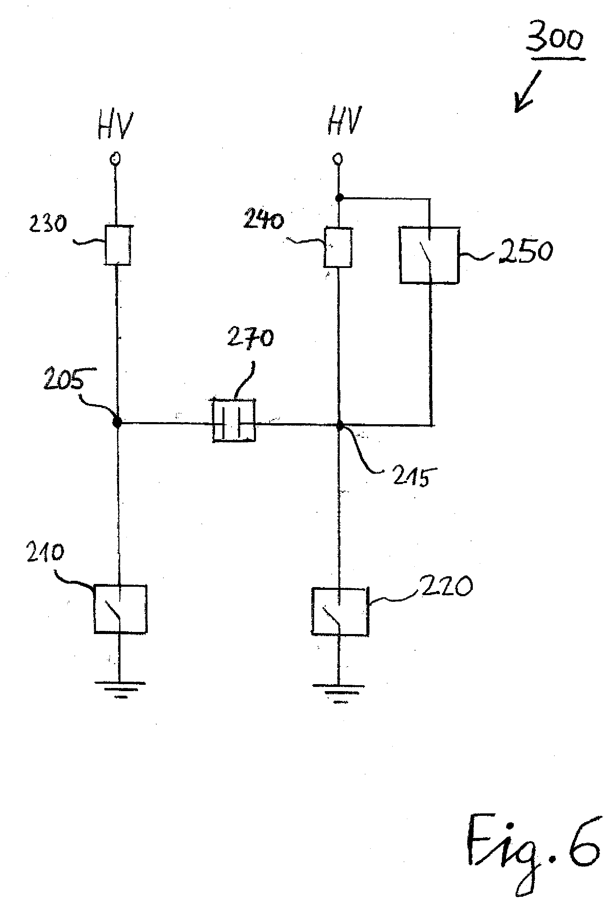

Dementsprechend ist in der Fig. 6 eine weitere Ausführungsform einer Brückenschaltung mit erfindungsgemäßen Schalteinheiten schematisch dargestellt. Die Brückenschaltung 300 entspricht im Wesentlichen der Brückenschaltung 200 der Fig.5, weist jedoch darüber hinausgehend eine weitere Schalteinheit 250 auf, die zwischen den zweiten Schaltungsknoten 215 und dem Hochspannungsanschluss geschaltet und somit zu dem zweiten Nachladewiderstand 240 parallel geschaltet ist. Die weitere Schalteinheiten 250 ist der Übersichtlichkeit halber in Blockform dargestellt. Sie kann bezüglich ihres inneren Aufbaus durch eine erfindungsgemässe Schalteinheit gegeben sein, wie sie in einer der Fig. 1-3 dargestellt und oben beschrieben worden sind.

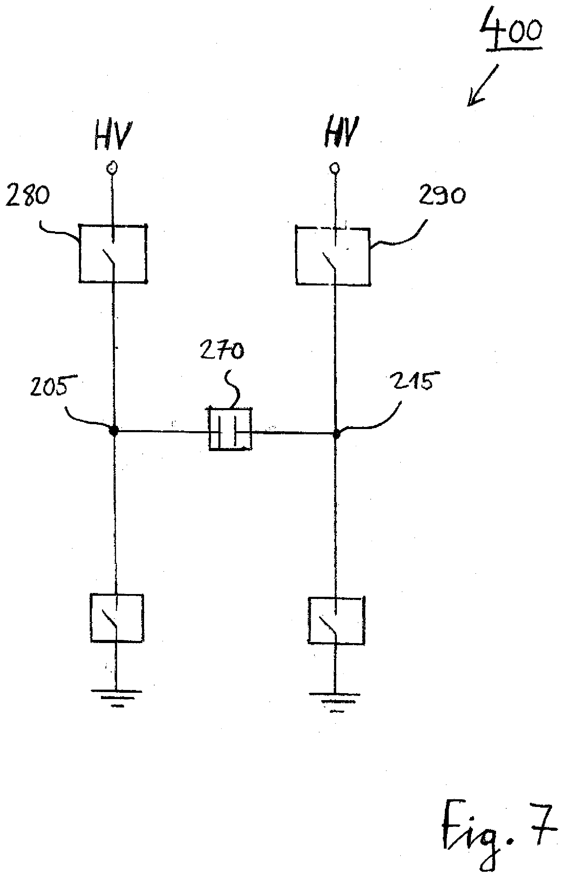

Weiterhin ist in der Fig. 7 eine weitere Ausführungsform einer Brückenschaltung mit erfindungsgemäßen Schalteinheiten schematisch dargestellt. Die Brückenschaltung 400 entspricht im Wesentlichen der Brückenschaltung 200 der Fig. 5, weist jedoch darüber hinausgehend zwei weitere Schalteinheiten 280 und 290 auf, die die Nachladewiderstände 230 und 240 der Brückenschaltung der Fig. 5 ersetzen. Die beiden weiteren Schalteinheiten 280 und 290 sind der Übersichtlichkeit halber in Blockform dargestellt und können bezüglich ihres inneren Aufbaus durch erfindungsgemässe Schalteinheiten gegeben sein, wie sie in einer der Fig. 1-3 dargestellt und oben beschrieben worden sind.

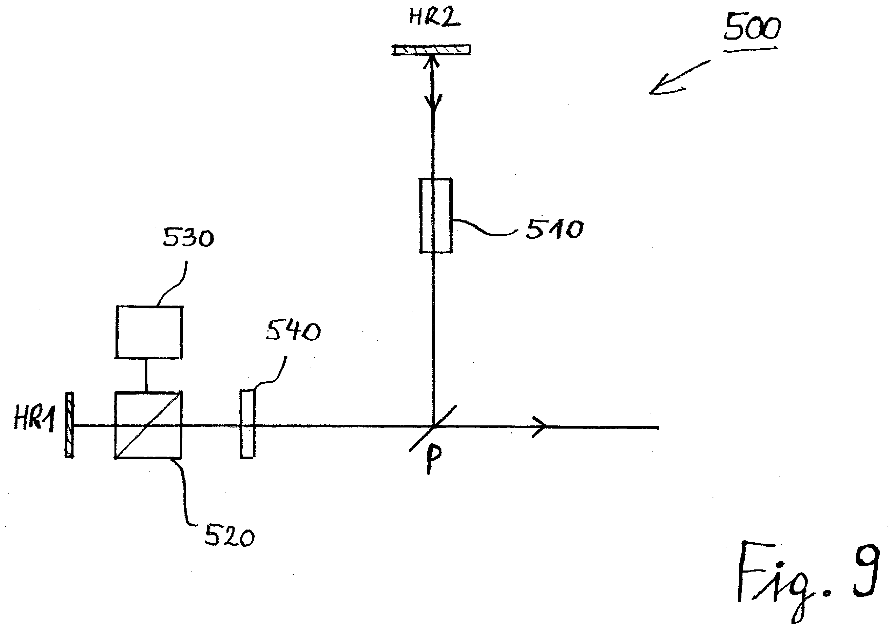

In der Fig. 9 ist eine Ausführungsform einer Laserstrahlquelle mit Cavity Dumper schematisch dargestellt. Die Laserstrahlquelle 500 weist einen cw-Resonator auf, der zwischen den hochreflektierenden Spiegeln HR1 und HR2 angeordnet ist. Innerhalb des Resonators befindet sich ein Verstärkungsmedium 510. Eine Pockelszelle 520 ist innerhalb des Resonators in relativer Nähe zu dem ersten hochreflektierenden Endspiegel HR1 angeordnet. Vor der Pockelszelle 520 ist ein Lambda/4-Plättchen 540 angeordnet. Der polarisationsabhängige Spiegel P reflektiert beispielsweise s-polarisiertes Licht vollständig, während er für p-polarisiertes Licht vollständig durchlässig ist. Die Pockelszelle 520 ist mit einer erfindungsgemässen Ansteuerschaltung 530 wie etwa einer Push-Pull-Schaltung oder einer Brückenschaltung wie weiter oben beschrieben verbunden.

Zwischen zwei Ausgangspulsen ist die Pockelszelle 520 spannungslos und somit optisch inaktiv, so dass die vom Verstärkungsmedium 510 kommende, beispielsweise s-polarisierte Laserstrahlung an dem Spiegel P reflektiert wird und nach zweifachem Durchgang durch die Pockelszelle 520, Lambda/4-Plättchen 540 und Reflektion an dem HR1 nun p-polarisiert ist, und von dem Spiegel P ausgekoppelt wird. Somit findet keine Verstärkung statt, wenn keine Spannung an der Pockelszelle 520 anliegt. Für die Pulserzeugung wird eine Spannung derart an die Pockelszelle 520 angelegt, dass diese bei zweifachem Durchgang eine Drehung der Polarisation um 90° bewirkt, welcher sich zusammen mit der Polarisationsdrehung durch das Lambda/4-Plättchen 540 auf 0° oder 180° addiert. In diesem Zustand ist der Resonator geschlossen, und es findet Verstärkung am Verstärkungsmedium 510 statt. Wenn nun langsam der Pockelszelle 520 die Spannung weggenommen wird, wirkt die Pockelszelle 520 somit zusammen mit dem Spiegel P als eine zeitabhängige Auskopplung. Die mit der Pockelszelle 520 verbundene erfindungsgemässe Ansteuerschaltung 530 bewirkt, dass mindestens eine der beiden Schaltflanken des Spannungspulses verlängert wird, so dass der aus dem Resonator ausgekoppelte Laserpuls eine gewünschte zeitliche Länge und eine entsprechend reduzierte Spitzenintensität erhält.

Es wird angemerkt, dass die in den Ausführungsbeispielen beschriebenen Merkmale und Elemente auch zwischen den Ausführungsbeispielen ausgetauscht werden können, sofern dies möglich und sinnvoll ist. Weitere Ausführungsbeispiele können im Rahmen der Erfindung aufgefunden werden, wie sie durch die folgenden Patentansprüche definiert wird.

## Patentansprüche

1. Schalteinheit, mit
einer Mehrzahl von Transistoren (TN), welche bezüglich ihrer Laststrecken in Serie geschaltet sind, wobei
mindestens ein Transistor (TN) mit seiner Laststrecke mit einem Eingang einer Strom-Messimpedanz (XN) verbunden ist, ein Ausgang der Strom-Messimpedanz (XN) mit einem zur Strom-Messimpedanz parallel geschalteten Kondensator (CN) verbunden ist und der Kondensator (CN) mit einer Steuerelektrode des Transistors (TN) verbunden ist, wobei die Strom-Messimpedanz (XN) einen Widerstand (RN) oder eine Kombination aus einem Widerstand und einem Kondensator enthält, wobei
die Transistoren (TN) Feldeffekt-Transistoren, insbesondere MOS-Transistoren sind und die Strom-Messimpedanz (XN) mit der Source des Transistors (TN) verbunden ist, und wobei die Steuerelektrode des Transistors (TN) mit einer Lade-/ Entladeschaltung (CLN) verbunden ist.

2. Schalteinheit nach Anspruch 1, bei welchem
alle Transistoren (TN) jeweils mit ihrer Laststrecke mit einer Strom-Messimpedanz (XN) verbunden sind, die Strom-Messimpedanz (XN) mit einem Kondensator (CN) verbunden ist und der Kondensator (CN) mit einer Steuerelektrode des Transistors (TN) verbunden ist.

3. Schalteinheit nach einem der Ansprüche 1 bis 2, bei welchem die Strom-Messimpedanz (XN) eine Diode (DN) enthält.

4. Push-Pull-Schaltung, mit
einem Schaltungsknoten (55),
einer ersten Schalteinheit (50) mit einem ersten Anschluss, welcher mit einem ersten Potential (HV) verbunden ist und mit einem zweiten Anschluss, welcher mit dem Schaltungsknoten (55) verbunden ist,
einer zweiten Schalteinheit (60), welche mit einem ersten Anschluss mit dem Schaltungsknoten (55) und mit einem zweiten Anschluss mit einem zweiten Potential verbunden ist, wobei die erste Schalteinheit (50) und/oder die zweite Schalteinheit (60) durch eine Schalteinheit nach einem der Ansprüche 1 bis 3 gegeben ist/sind.

5. Brückenschaltung, mit
einem ersten Schaltungsknoten (205) und einem zweiten Schaltungsknoten (215), wobei
der erste Schaltungsknoten (205) durch eine erste Leitung mit einem ersten Potential und durch eine zweite Leitung über eine erste Schalteinheit (210) mit einem zweiten Potential verbunden ist, und
der zweite Schaltungsknoten (215) durch eine dritte Leitung mit dem ersten Potential und durch eine vierte Leitung über eine zweite Schalteinheit (210) mit dem zweiten Potential verbunden ist, wobei
die erste Schalteinheit (210) und/oder die zweite Schalteinheiten (220) durch eine Schalteinheit nach einem der Ansprüche 1 bis 3 gegeben ist.

6. Laserstrahlquelle, mit
einem Laserresonator,
einer im Laserresonator angeordneten Pockelszelle (520), und einer mit der Pockelszelle verbundenen Push-Pull-Schaltung nach Anspruch 4.

7. Laserstrahlquelle, mit
einem Laserresonator,
einer im Laserresonator angeordneten Pockelszelle (520), und einer mit der Pockelszelle verbundenen Brückenschaltung nach Anspruch 5.

8. Laserstrahlquelle nach Anspruch 6 oder 7, bei welcher die Pockelszelle (520) derart im Laserresonator angeordnet ist und derart ansteuerbar ist, dass sie als ein Cavity Dumper wirkt.

## Claims

1. Switching unit, with
a plurality of transistors (TN) which are connected in series with respect to their load paths, wherein
at least one transistor (TN) is connected with its load path to an input of a current measuring impedance (XN), an output of the current measuring impedance (XN) is connected to a capacitor (CN) connected in parallel with the current measuring impedance, and the capacitor (CN) is connected to a control electrode of the transistor (TN), the current measuring impedance (XN) containing a resistor (RN) or a combination of a resistor and a capacitor, where
the transistors (TN) are field-effect transistors, in particular MOS transistors, and the current measuring impedance (XN) is connected to the source of the transistor (TN), and wherein the control electrode of the transistor (TN) is connected to a charge/discharge circuit (CLN).

2. Switching unit according to claim 1, in which
all transistors (TN) are each connected with their respective load path to a current-measuring impedance (XN), the current-measuring impedance (XN) is connected to a capacitor (CN) and the capacitor (CN) is connected to a control electrode of the transistor (TN).

3. Switching unit according to any one of claims 1 to 2, in which the current measuring impedance (XN) contains a diode (DN).

4. Push-pull circuit, with
a circuit node (55),
a first switching unit (50) having a first terminal connected to a first potential (HV) and having a second terminal connected to the circuit node (55),
a second switching unit (60) having a first terminal connected to the circuit node (55) and a second terminal connected to a second potential, wherein
the first switching unit (50) and/or the second switching unit (60) is/are given by a switching unit according to one of claims 1 to 3.

5. Bridge circuit, with
a first circuit node (205) and a second circuit node (215), wherein
the first circuit node (205) is connected by a first line to a first potential and by a second line via a first switching unit (210) to a second potential, and
the second circuit node (215) is connected by a third line to the first potential and by a fourth line via a second switching unit (210) to the second potential, wherein
the first switching unit (210) and/or the second switching unit (220) is given by a switching unit according to any one of claims 1 to 3.

6. Laser beam source, with
a laser resonator,
a Pockels cell (520) arranged in the laser resonator, and
a push-pull circuit according to claim 4 connected to the Pockels cell.

7. Laser beam source, having
a laser resonator,
a Pockels cell (520) arranged in the laser resonator, and
a bridge circuit according to claim 5 connected to the Pockels cell.

8. Laser beam source according to claim 6 or 7, in which
the Pockels cell (520) is arranged in the laser resonator and can be driven in such a way that it acts as a cavity dumper.

## Revendications

1. Unité de commutation, avec
une pluralité de transistors (TN) qui sont connectés en série par rapport à leurs chemins de charge, dans laquelle au moins un transistor (TN) est relié par son trajet de charge à une entrée d'une impédance de mesure de courant (XN), une sortie de l'impédance de mesure de courant (XN) est reliée à un condensateur (CN) monté en parallèle avec l'impédance de mesure de courant et le condensateur (CN) est relié à une électrode de commande du transistor (TN), l'impédance de mesure de courant (XN) contenant une résistance (RN) ou une combinaison d'une résistance et d'un condensateur, où
les transistors (TN) sont des transistors à effet de champ, en particulier des transistors MOS, et l'impédance de mesure du courant (XN) est reliée à la source du transistor (TN), et dans lequel
l'électrode de commande du transistor (TN) est reliée à une charge/décharge
Le circuit de décharge (CLN) est connecté.

2. Unité de commutation selon la revendication 1, dans laquelle tous les transistors (TN) sont reliés par leur trajet de charge à une impédance de mesure de courant (XN), l'impédance de mesure de courant (XN) est reliée à un condensateur (CN) et le condensateur (CN) est relié à une électrode de commande du transistor (TN) .

3. Unité de commutation selon l'une quelconque des revendications 1 à 2, dans laquelle
l'impédance de mesure du courant (XN) contient une diode (DN).

4. Circuit push-pull, avec
un noeud de circuit (55),
une première unité de commutation (50) ayant une première borne connectée à un premier potentiel (HV) et ayant une deuxième borne connectée au noeud de circuit (55),
une deuxième unité de commutation (60) ayant une première borne connectée au noeud de circuit (55) et une deuxième borne connectée à un deuxième potentiel, dans laquelle
la première unité de commutation (50) et/ou la deuxième unité de commutation (60) est/sont donnée (s) par une unité de commutation selon l'une des revendications 1 à 3.

5. Circuit en pont, avec
un premier noeud de circuit (205) et un second noeud de circuit (215), dans lequel
le premier noeud de circuit (205) est relié par une première ligne à un premier potentiel et par une deuxième ligne via une première unité de commutation (210) à un deuxième potentiel, et
le deuxième noeud de circuit (215) est relié par une troisième ligne au premier potentiel et par une quatrième ligne via une deuxième unité de commutation (210) au deuxième potentiel, dans lequel
la première unité de commutation (210) et/ou la deuxième unité de commutation (220) est donnée par une unité de commutation selon l'une quelconque des revendications 1 à 3.

6. Source de faisceau laser, avec
un résonateur laser,
une cellule de Pockels (520) disposée dans le résonateur laser, et
un circuit push-pull connecté à la cellule de Pockels selon la revendication 4.

7. Source de faisceau laser, ayant
un résonateur laser,
une cellule de Pockels (520) disposée dans le résonateur laser, et
un circuit en pont connecté à la cellule de Pockels selon la revendication 5.

8. Source de faisceau laser selon la revendication 6 ou 7, dans laquelle
la cellule de Pockels (520) est disposée dans le résonateur laser et peut être commandée de telle sorte qu'elle agit comme un dumper de cavité.
